# DEMANDE DE BREVET EUROPEEN

(11) **EP 1 876 647 A2**
(43) Date de publication de la demande: **09.01.2008**
(21) Numéro de dépôt: 07111519.0
(22) Date de dépôt: 02.07.2007
(51) Int. Cl.: H01L 27/146

(54) **Capteur d'images éclairé par la face arrière**

(30) Priorité: 05.07.2006 FR 0652817
(71) Demandeur: ST MICROELECTRONICS S.A., 92120 Montrouge (FR)
(72) Inventeur: Cazaux, Yvon, 38100, GRENOBLE (FR); Roy, François, 38180, SEYSSINS (FR)
(74) Mandataire: de Beaumont, Michel

(57) **Abrégé**

L'invention concerne un capteur d'images comprenant une couche (26) d'un matériau semi-conducteur dopée de type P comprenant des première (16) et seconde (20) faces opposées ; et au moins une photodiode (D₂) formée dans la couche du côté de la première face (16) et destinée à être éclairée par la seconde face (20). La concentration de dopants de la couche (26) augmente de la première face (16) vers la seconde face (20).

## Description

### Domaine de l'invention

La présente invention concerne le domaine des capteurs d'images destinés à être utilisés dans des téléphones portables, des caméras, des caméscopes ou des appareils photographiques numériques. Elle concerne plus particulièrement des capteurs d'images réalisés de façon monolithique à base de matériaux semi-conducteurs.

### Exposé de l'art antérieur

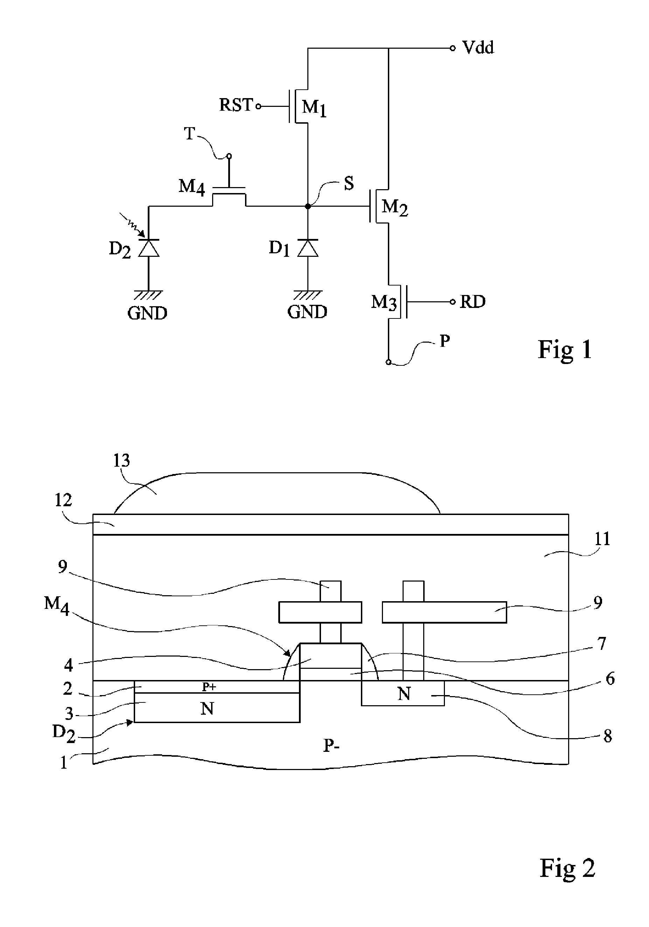

La figure 1 illustre schématiquement un exemple de circuit d'une cellule photosensible d'une matrice de cellules photosensibles d'un capteur d'images. A chaque cellule photosensible de la matrice sont associés un dispositif de précharge et un dispositif de lecture. Le dispositif de précharge est constitué d'un transistor MOS à canal N M₁, interposé entre un rail d'alimentation Vdd et un noeud de lecture S. La grille du transistor de précharge M₁ est propre à recevoir un signal de commande de précharge RST. Le dispositif de lecture est constitué de la connexion en série de premier et second transistors MOS à canal N M₂, M₃. Le drain du premier transistor de lecture M₂ est connecté au rail d'alimentation Vdd. La source du second transistor de lecture M₃ est connectée à une borne d'entrée P d'un circuit de traitement (non représenté). La grille du premier transistor de lecture M₂ est reliée au noeud de lecture S. La grille du deuxième transistor de lecture M₃ est propre à recevoir un signal de lecture RD. La cellule photosensible comprend une diode de stockage de charge D₁ dont l'anode est reliée à une source d'un potentiel de référence ou masse du circuit GND et la cathode est reliée directement au noeud S. La cellule photosensible comprend une photodiode D₂ dont l'anode est reliée au rail d'alimentation de référence GND et la cathode est reliée au noeud S par l'intermédiaire d'un transistor MOS à canal N de transfert de charges M₄. La grille du transistor de transfert M₄ est propre à recevoir un signal de commande de transfert de charges T. De façon générale, les signaux RD, RST, et T sont fournis par des circuits de commande non représentés en figure 1 et peuvent être fournis à l'ensemble des cellules photosensibles d'une même rangée de la matrice de cellules. La diode D₁ peut ne pas être réalisée par un composant spécifique. La fonction de stockage des charges issues de la photodiode D₂ est alors assurée par la capacité apparente au noeud de lecture S qui est constituée des capacités des sources des transistors M₁ et M₄, de la capacité d'entrée du transistor M₂ ainsi que de l'ensemble des capacités parasites présentes au noeud S.

Le fonctionnement de ce circuit va maintenant être décrit. Un cycle de photodétection commence par une phase de précharge pendant laquelle on impose à la diode D₁ un niveau de tension de référence. Cette précharge s'effectue en rendant passant le transistor de précharge M₁. Une fois la précharge effectuée, le transistor de précharge M₁ est bloqué. On lit alors l'état au noeud S, c'est à dire l'état de charge de référence réel de la diode D₁. Le cycle se poursuit par un transfert vers le noeud S des charges photogénérées, c'est-à-dire créées et stockées en présence d'un rayonnement, dans la photodiode D₂. Ce transfert s'effectue en rendant passant le transistor de transfert M₄. Le transfert fini, le transistor M₄ est bloqué et la photodiode D₂ recommence à photogénérer et stocker des charges qui seront ultérieurement transférées vers le noeud S. Simultanément, à la fin du transfert, on lit le nouvel état de charge de la diode D₂. Le signal de sortie transmis à la borne P dépend alors du pincement du canal du premier transistor de lecture M₂, qui est directement fonction de la charge stockée dans la photodiode.

La figure 2 illustre schématiquement une cellule photosensible ou pixel d'un capteur d'images classique destiné à être éclairé par la face avant. Seuls la photodiode D₂ et le transistor M₄ sont représentés. Dans un substrat 1 de type P⁻, on prévoit une région 2 de type P plus fortement dopée que le substrat 1 et une région 3 dopée N pincée entre la région 2 et le substrat 1 qui correspondent à la photodiode D₂ qui a une structure dite pincée. La cellule comprend une portion de silicium polycristallin 4 disposée sur une portion isolante 6, des espaceurs 7 étant prévus de part et d'autre des portions 4, 6. La portion de silicium polycristallin 4 correspond à la grille du transistor M₄ et la portion isolante 6 correspond à l'oxyde de grille du transistor M₄. On prévoit, dans le substrat 1, une région 8 de type N correspondant au noeud de lecture de la cellule photosensible. Des interconnexions métalliques, sous forme de pistes et de vias métalliques 9, sont formées au niveau d'un empilement de couches isolantes 11 recouvrant le substrat 1 et sont reliées aux composants de la cellule. La cellule comprend également un filtre coloré 12 recouvrant l'empilement de couches isolantes 11 sur lequel une microlentille 13 est disposée.

Les rayons lumineux qui atteignent la microlentille 13 sont focalisés vers la photodiode D₂. Toutefois, des rayons lumineux incidents peuvent être déviés ou bloqués par les interconnexions 9 et ne pas atteindre la photodiode D₂. En outre, la tendance actuelle étant à la réduction des dimensions des cellules photosensibles, le problème de la présence des interconnexions métalliques 9 devient d'autant plus important. Pour pallier à ce problème, il a été imaginé un éclairage de la photodiode D₂ par la face arrière du substrat 1.

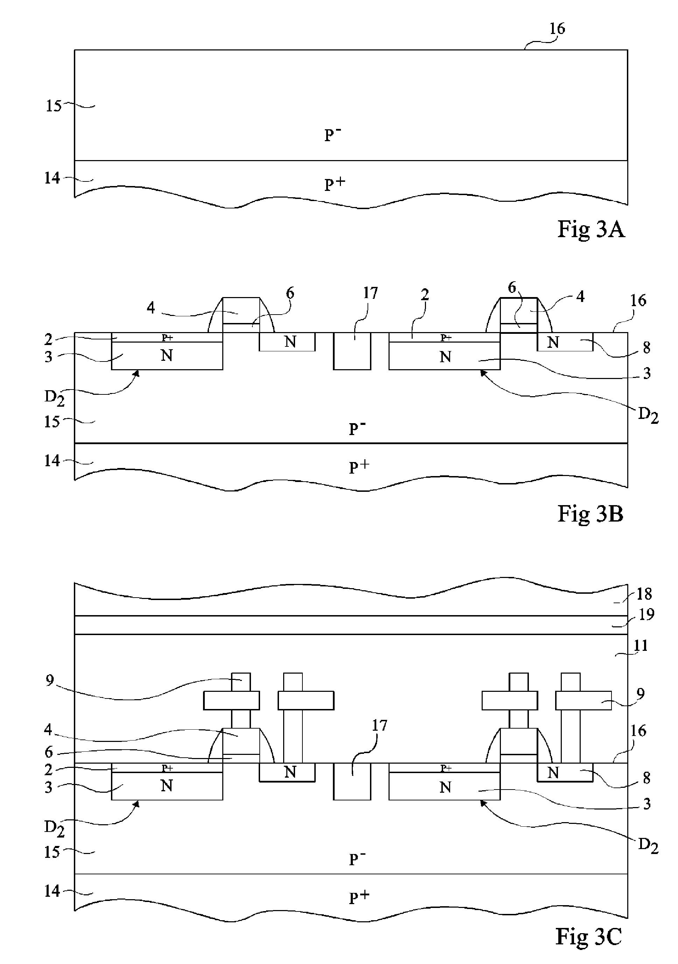

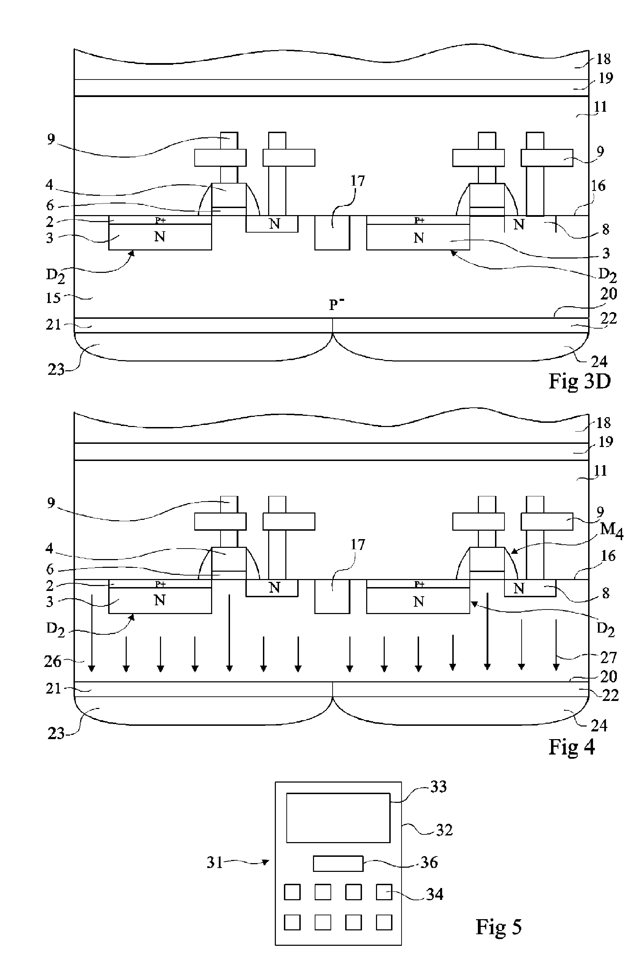

Les figures 3A à 3D illustrent schématiquement des étapes d'un exemple de procédé classique de fabrication d'un capteur d'images éclairé par la face arrière. La figure 3A représente un substrat 14 de type P fortement dopé sur lequel a été réalisée par épitaxie une couche 15 de silicium mono- cristallin de type P moins fortement dopée que le substrat 14. La couche 15 comprend une face avant 16 et a, par exemple, une épaisseur d'environ 3 µm. La figure 3B représente la structure obtenue après avoir réalisé au niveau de la couche 15 les composants associés aux pixels. En figure 3B, on a représenté deux pixels adjacents. Les éléments communs au pixel représenté en figure 2 sont désignés avec les mêmes références. Pour assurer l'isolation entre les deux pixels, on a réalisé dans la couche 15 une zone d'isolation 17, par exemple en oxyde de silicium. La figure 3C représente la structure obtenue après avoir réalisé les niveaux d'interconnexions 9 dans l'empilement de couches isolantes 11 recouvrant la couche 15 et après avoir collé sur l'empilement de couches isolantes 11 un second substrat 18 sur lequel on a fait croître une couche d'oxyde de silicium 19. La figure 3D représente la structure obtenue après avoir retiré le substrat 14, par exemple par un procédé de polissage mécano-chimique, pour définir une face arrière 20 de la couche 15 et après avoir réalisé sur la face arrière 20 des filtres de couleur 21 et 22 et des microlentilles 23 et 24.

Un inconvénient de la structure de capteur d'images représentée sur la figure 3D résulte de la diffusion des électrons dans la couche 15. En effet, de façon générale, les photons incidents entraînent la formation dans la couche 15 de paires électron/trou, les électrons se formant dans une portion de la couche 15 associée à une cellule photosensible devant être capturés par la photodiode de cette cellule. Toutefois, on observe que certains électrons issus de l'absorption des photons dans une portion de la couche 15 associée à une cellule photosensible donnée peuvent être capturés par les photodiodes des cellules photosensibles adjacentes. Ceci se traduit par un bruit indésirable sur les signaux mesurés aux noeuds de lecture dont l'amplitude varie pour chaque cellule photosensible. Un tel phénomène est dû à la diffusion d'électrons se formant dans une portion de la couche 15 associée à une cellule photosensible donnée vers les photodiodes des cellules adjacentes plutôt que vers la photodiode de la cellule photosensible donnée. Le risque de diffusion d'électrons vers les cellules adjacentes est d'autant plus important que le lieu de formation des électrons est éloigné des photodiodes.

Lorsque le capteur d'images est éclairé par la face avant, ce phénomène est relativement peu important. En effet, les photons dont les longueurs d'onde correspondent au bleu ou au vert sont principalement absorbés dans les deux premiers micromètres du substrat 1. En raison de la focalisation des rayons lumineux par la lentille 13, les électrons issus de l'absorption de tels photons se forment principalement à proximité de la photodiode D₂. Le risque que certains de ces électrons diffusent vers les cellules photosensibles adjacentes est donc faible. Seuls les photons dont la longueur d'onde correspond au rouge peuvent être absorbés sur une épaisseur plus importante du substrat 1. Le risque que certains de ces électrons diffusent vers les cellules adjacentes est alors plus important, mais le nombre global d'électrons susceptibles de diffuser vers des cellules adjacentes reste faible.

Au contraire, lorsque le capteur d'images est éclairé par la face arrière, le risque de diffusion d'électrons vers les cellules photosensibles adjacentes est plus important. En effet, les électrons qui ont le plus de risque de diffuser vers les cellules photosensibles adjacentes sont ceux qui se forment dans les deux premiers micromètres de la couche 15 depuis la face arrière 20. Le nombre de ces électrons est plus important que pour un capteur d'images éclairé par la face avant puisqu'ils proviennent de l'absorption de photons correspondant aux couleurs bleue, verte et rouge. La perturbation des signaux mesurés en raison de la diffusion d'électrons vers les cellules photosensibles adjacentes est donc plus importante pour un capteur d'images éclairé par la face arrière.

### Résumé de l'invention

Un objet de la présente invention est de prévoir un capteur d'images éclairé par la face arrière permettant de réduire, voire de supprimer, la diffusion d'électrons associés à un pixel donné vers les pixels adjacents.

Un autre objet de la présente invention est de prévoir un procédé de fabrication d'un capteur d'images éclairé par la face arrière permettant de réduire, voire de supprimer, la diffusion d'électrons associés à un pixel donné vers les pixels adjacents.

Pour atteindre tout ou partie de ces objets ainsi que d'autres, un aspect de la présente invention prévoit un capteur d'images comprenant une couche d'un matériau semi-conducteur dopée de type P comprenant des première et seconde faces opposées ; et au moins une photodiode formée dans la couche du côté de la première face et destinée à être éclairée par la seconde face. La concentration de dopants de la couche augmente de la première face vers la seconde face.

Selon un exemple de réalisation de la présente invention, l'augmentation de la concentration de dopants de la couche est sensiblement continue.

Selon un exemple de réalisation de la présente invention, la concentration de dopants de la couche augmente par paliers successifs.

Selon un exemple de réalisation de la présente invention, la concentration en dopants de la couche est sensiblement constante sur une épaisseur donnée depuis la première face.

Selon un exemple de réalisation de la présente invention, l'épaisseur donnée est de 1 µm.

Selon un exemple de réalisation de la présente invention, l'épaisseur de la couche est comprise entre 2 µm et 4 µm.

Un autre aspect de la présente invention prévoit un dispositif, notamment un téléphone portable, une caméra, un caméscope, un microscope numérique ou un appareil photographique numérique, comprenant un capteur d'images tel que précédemment défini.

Un autre aspect de la présente invention prévoit un procédé de fabrication d'un capteur d'images comprenant les étapes consistant à former une couche d'un matériau semi-conducteur dopée de type P comprenant des première et seconde faces opposées, la concentration de dopants de la couche augmentant de la première face vers la seconde face ; et à former dans la couche au moins une photodiode du côté de la première face et destinée à être éclairée par la seconde face.

Selon un exemple de réalisation de la présente invention, la couche est formée par épitaxie.

Selon un exemple de réalisation de la présente invention, la couche est formée sur une couche isolante recouvrant un substrat, le substrat et au moins une partie de ladite couche isolante étant retirés après formation de ladite photodiode.

### Brève description des dessins

Ces objets, caractéristiques et avantages, ainsi que d'autres de la présente invention seront exposés en détail dans la description suivante d'un exemple de réalisation particulier faite à titre non-limitatif en relation avec les figures jointes parmi lesquelles :
la figure 1, précédemment décrite, représente un schéma électrique d'une cellule photosensible ;
la figure 2, précédemment décrite, représente un capteur d'images classique éclairé par la face avant ;
les figures 3A à 3D, précédemment décrites, illustrent les étapes successives d'un procédé classique de fabrication d'un capteur d'images éclairé par la face arrière ;
la figure 4 représente un exemple de réalisation d'un capteur d'images éclairé par la face arrière selon l'invention ; et
la figure 5 représente, de façon schématique, un téléphone portable comprenant un capteur d'images selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

La figure 4 est une figure analogue à la figure 3D et représente un exemple de réalisation d'un capteur d'images selon l'invention. Par rapport au capteur d'images représenté en figure 3D, la couche 15 de type P faiblement dopée a été remplacée par une couche 26 de silicium dopée de type P dont la concentration en dopants augmente depuis la face avant 16 de la couche 26 jusqu'à la face arrière 20. A titre d'exemple, l'épaisseur de la couche 26 peut varier entre 2 µm et 6 µm et la concentration en dopants peut varier de quelques 10¹⁴ atomes/cm³ près de la face avant 16 à quelques 10¹⁷ atomes/cm³ près de la face arrière 20. Le dopant utilisé est de type P, et correspond par exemple, au bore. Les flèches 27 illustrent le gradient de concentration de dopants dans la couche 26. Le procédé de fabrication du présent exemple de réalisation du capteur d'images selon l'invention peut être analogue au procédé précédemment décrit en relation aux figures 3A à 3D, la couche 26 étant réalisée par épitaxie sur le substrat 14. On prévoit alors, simultanément à la croissance épitaxiale de la couche 26, de réaliser un dopage de type P dont la concentration augmente dans le sens des flèches 27.

Le gradient de concentration de dopants entraîne la formation d'un champ électrostatique dans la couche 26 orienté comme le gradient de concentration. Ceci se traduit par l'exercice d'une force sur les électrons se formant dans la couche 26 orientée dans le sens opposé aux flèches 27. Les électrons sont donc conduits vers la photodiode D₂ associée à la portion de la couche 26 du pixel dans laquelle ils se sont formés. Le champ électrostatique empêche donc les électrons de diffuser vers les pixels voisins.

L'augmentation de la concentration de dopants peut être effectuée de manière continue et régulière de la face avant 16 vers la face arrière 20 de la couche 26. A titre d'exemple, l'augmentation de la concentration peut être rectiligne.

La concentration de dopants dans la couche 26 peut être constante sur une épaisseur donnée depuis la face avant 16 de la couche 26 puis augmenter jusqu'à la face arrière 20. L'épaisseur donnée peut être de l'ordre de 1 µm. Ceci permet avantageusement de maintenir la concentration de dopants constante au niveau des portions de la couche 26 correspondant aux régions de canal des transistors des cellules photosensibles. En effet, la mise au point électrique d'un transistor MOS afin d'optimiser son fonctionnement est très sensible et est généralement réalisée en considérant que la portion de silicium dans laquelle est formé le transistor a une concentration de dopants constante. Il peut donc être avantageux d'avoir une concentration de dopants constante au niveau de chaque transistor de la cellule photosensible pour ne pas modifier le point de fonctionnement de ce transistor et notamment les conditions de formation du canal du transistor.

Selon une variante de la présente invention, la zone d'isolation 17 peut correspondre à une région de type P plus fortement dopée que la couche 26. La zone d'isolation 17 peut être formée par une ou plusieurs étapes d'implantation. Elle peut s'étendre depuis la face avant 16 sur l'épaisseur donnée sur laquelle la concentration de dopants dans la couche 26 est constante.

Selon un mode de mise en oeuvre de la présente invention, on peut utiliser, pour la formation de la couche 26, une structure du type SOI (acronyme anglais pour Silicon On Insulator). On part de la couche de silicium supérieure de la structure SOI, qui constitue une couche d'accroche. La couche de silicium 26 à concentration de dopants variable peut être réalisée par épitaxie sur la couche d'accroche.

Selon une variante de mise en oeuvre, on part de la couche de silicium supérieure d'une structure SOI, qui constitue de nouveau une couche d'accroche. La couche 26 à concentration de dopants variable peut alors être réalisée en dopant fortement la couche d'accroche sur la couche isolante de la structure SOI et en faisant croître par épitaxie à concentration de dopants constante la couche 26 sur la couche d'accroche. Il se produit alors, pendant l'épitaxie, une exo-diffusion des dopants, à partir de la couche d'accroche, dans la couche 26.

La figure 5 illustre un exemple d'utilisation du capteur d'images selon l'invention. La figure 5 représente, de façon schématique, un téléphone portable 31 comprenant un boîtier 32 au niveau duquel sont disposés un écran 33 et un clavier 34. Le téléphone portable comprend également un système d'acquisition d'images 36 comportant un système optique dirigeant les rayons lumineux vers un capteur d'images selon l'invention.

Bien entendu, la présente invention est susceptible de diverses variantes et modifications qui apparaîtront à l'homme de l'art. En particulier, la présente invention s'applique également à une cellule photosensible pour laquelle plusieurs photodiodes sont reliées à un même noeud de lecture. En outre, bien que la présente invention ait été décrite pour une cellule de capteurs d'images dans laquelle le dispositif de précharge et le dispositif de lecture ont une structure particulière, la présente invention s'applique également à une cellule pour laquelle le dispositif de précharge ou le dispositif de lecture ont une structure différente, par exemple comprennent un nombre différent de transistors MOS.

## Revendications

1. Capteur d'images comprenant :
une couche (26) d'un matériau semi-conducteur dopée de type P comprenant des première (16) et seconde (20) faces opposées ; et
au moins une photodiode (D₂) formée dans ladite couche du côté de la première face (16) et destinée à être éclairée par la seconde face (20),
**caractérisé en ce que** la concentration de dopants de ladite couche (26) augmente de la première face (16) vers la seconde face (20), la concentration en dopants de ladite couche étant sensiblement constante sur une épaisseur donnée depuis la première face.

2. Capteur d'images selon la revendication 1, dans lequel l'augmentation de la concentration de dopants de ladite couche (26) est sensiblement continue.

3. Capteur d'images selon la revendication 1, dans lequel la concentration de dopants de ladite couche (26) augmente par paliers successifs.

4. Capteur d'images selon la revendication 1, comprenant, dans ladite couche (26), sur l'épaisseur donnée depuis la première face, une zone d'isolation (17) de type P plus fortement dopée que ladite couche et entourant au moins en partie ladite photodiode (D₂).

5. Capteur d'images selon la revendication 4, dans lequel l'épaisseur donnée est de 1 µm.

6. Capteur d'images selon l'une quelconque des revendications précédentes dans lequel l'épaisseur de ladite couche (26) est comprise entre 2 µm et 4 µm.

7. Dispositif, notamment un téléphone portable (31), une caméra, un caméscope, un microscope numérique ou un appareil photographique numérique, comprenant un capteur d'images selon l'une quelconque des revendications précédentes.

8. Procédé de fabrication d'un capteur d'images comprenant les étapes suivantes :
former une couche (26) d'un matériau semiconducteur dopée de type P comprenant des première (16) et seconde (20) faces opposées, la concentration de dopants de ladite couche (26) augmentant de la première face (16) vers la seconde face (20) et étant sensiblement constante sur une épaisseur donnée depuis la première face ; et
former dans ladite couche (26) au moins une photodiode (D₂) du côté de la première face (16) et destinée à être éclairée par la seconde face (20).

9. Procédé selon la revendication 8, dans lequel ladite couche (26) est formée par épitaxie.

10. Procédé selon la revendication 8, dans lequel ladite couche (26) est formée sur une couche isolante recouvrant un substrat, le substrat et au moins une partie de ladite couche isolante étant retirés après la formation de ladite photodiode.
